# EUROPEAN PATENT APPLICATION

(11) **EP 4 675 680 A1**
(43) Date of publication of application: **07.01.2026**
(21) Application number: 23928436.7
(22) Date of filing: 15.12.2023
(51) Int. Cl.: H01L 23/48, H01L 23/52

(54) **CHIP STACKING STRUCTURE AND ELECTRONIC DEVICE**

(30) Priority: 21.03.2023 CN 202310312057
(71) Applicant: Huawei Technologies Co., Ltd., Shenzhen, Guangdong 518129 (CN)
(72) Inventor: CHEN, Longjun, Shenzhen, Guangdong 518129 (CN); HUANG, Tianqiang, Shenzhen, Guangdong 518129 (CN); LIU, Rongbin, Shenzhen, Guangdong 518129 (CN); WANG, Zhengbo, Shenzhen, Guangdong 518129 (CN); LIU, Yun, Shenzhen, Guangdong 518129 (CN)
(74) Representative: Epping - Hermann - Fischer
(86) International application number: PCT/CN2023/139295
(87) International publication number: WO 2024/193132

(57) **Abstract**

Embodiments of this application provide a chip stacking structure and an electronic device, and relate to the field of chip manufacturing technologies, to alleviate a problem of a large plane dimension of a chip. In the chip stacking structure, a third die, a second die, and a first die are sequentially stacked on a carrier board. A first redistribution layer and a first interface component of the first die form a first interface circuit, and a second redistribution layer and a second interface component of the second die form a second interface circuit. A first conductive structure penetrates through at least the second die and the third die, and a second conductive structure penetrates through at least the third die. The first interface circuit of the first die and the second interface circuit of the second die are separately electrically connected to another component through the insulated first conductive structure and the insulated second conductive structure.

## Description

This application claims priority to Chinese Patent Application No. 202310312057.4, filed with the China National Intellectual Property Administration on March 21, 2023 and entitled "CHIP STACKING STRUCTURE AND ELECTRONIC DEVICE", which is incorporated herein by reference in its entirety.

### TECHNICAL FIELD

This application relates to the field of chip manufacturing technologies, and in particular, to a chip stacking structure and an electronic device.

### BACKGROUND

With continuous development of a semiconductor process, users have increasingly high requirements on function diversification and an information processing speed of an electronic device. Therefore, a component with high integration and high performance needs to be disposed in limited two-dimensional component arrangement space of the electronic device. Currently, to reduce an outline dimension of the component, a stacking technology may be used to vertically stack a plurality of chips in three-dimensional space to form the component. However, a plane dimension of a single chip in the component is still large, which restricts further reduction of a component dimension.

### SUMMARY

This application provides a chip stacking structure and an electronic device, to alleviate a problem of a large plane dimension of a chip.

To achieve the foregoing objective, the following technical solutions are used in this application.

According to an aspect of this application, a chip stacking structure is provided. The chip stacking structure may include a carrier board, a first die, a second die, and a third die. The first die is disposed on the carrier board, the second die is disposed between the carrier board and the first die, and the third die is disposed between the carrier board and the second die. In this case, in a direction away from the carrier board, the third die, the second die, and the third die are sequentially stacked on the carrier board. The first die includes a first interface component, and the second die includes a second interface component. In addition, the chip stacking structure further includes a first redistribution layer, a second redistribution layer, a first conductive structure, and a second conductive structure. The first conductive structure penetrates through at least the second die and the third die. The first redistribution layer is disposed on an active surface of the first die, and is electrically connected to the first interface component and the first conductive structure. The second conductive structure penetrates through at least the third die. The second redistribution layer is disposed on an active surface of the second die, and is electrically connected to the second interface component and the second conductive structure. In addition, the first redistribution layer is insulated from the second conductive structure, and the second redistribution layer is insulated from the first conductive structure.

It can be learned from the foregoing that the first redistribution layer is electrically connected to the first interface component, so that the first interface component and a part of the first redistribution layer can form a first interface circuit, and the first interface circuit may be electrically connected to the first conductive structure, so that the first die can implement signal interworking with another component through the first interface circuit and the first conductive structure. Similarly, the second redistribution layer is electrically connected to the second interface component, so that the second interface component and a part of the second redistribution layer can form a second interface circuit, and the second interface circuit may be electrically connected to the second conductive structure, so that the second die can implement signal interworking with another component through the second interface circuit and the second conductive structure.

In addition, the first redistribution layer is insulated from the second conductive structure, and the second redistribution layer is insulated from the first conductive structure. In this case, the first redistribution layer and the second redistribution layer may be disposed in a heterogeneous manner. To be specific, a metal trace at the first redistribution layer and a metal trace at the second redistribution layer may be prepared by using different masks, so that a pattern of the metal trace at the first redistribution layer is different from a pattern of the metal trace at the second redistribution layer. In this case, the metal trace at the first redistribution layer only needs to electrically connect the first interface component to the first conductive structure, so that the first interface circuit that is of the first die and that includes the first redistribution layer and the first interface component is electrically connected to the first conductive structure, and the first interface circuit does not need to be electrically connected to the second interface circuit of the second die. Similarly, a metal pattern layer at the second redistribution layer only needs to electrically connect the second interface component to the second conductive structure, so that the second interface circuit that is of the second die and that includes the second redistribution layer and the second interface component is electrically connected to the second conductive structure, and the second interface circuit does not need to be electrically connected to the first interface circuit of the first die. The first interface circuit is insulated from the second interface circuit, so that when the first die, the second die, and the third die are simultaneously in an operating state, the first interface circuit of the first die and the second interface circuit of the second die can independently transmit a signal to another component through the first conductive structure and the second conductive structure respectively.

Based on this, redistribution layers on active surfaces of any two chips in chips stacked in a related technology are manufactured by using a same mask, that is, homogeneously designed. In this case, a plurality of interface circuits need to be disposed in each chip, each interface circuit is electrically connected to all vertical interconnection structures, and one of the plurality of interface circuits in the same chip is controlled, by using a circuit, to be in an operating state. In this way, remaining interface circuits are not effectively used in actual operating, and therefore are referred to as a redundancy design. As a result, a plane dimension of the chip is increased. Therefore, in comparison with the foregoing homogeneous design solution, in this application, the first redistribution layer and the second redistribution layer are heterogeneously designed, and only one interface circuit that actually participates in operating needs to be disposed in one die, so that a quantity of interface circuits of a single die can be reduced, to reduce a plane dimension of the chip stacking structure.

In an optional implementation, the first conductive structure includes a first middle-layer via and a first lower-layer via. The first middle-layer via penetrates through the second die, and one end of the first middle-layer via is electrically connected to the first redistribution layer. The first lower-layer via penetrates through the third die, and one end of the first lower-layer via is electrically connected to the other end of the first middle-layer via. In this way, in the first conductive structure, the first lower-layer via and the first middle-layer via that are electrically connected to each other may electrically connect the first interface circuit of the first die to another component, so that the first conductive structure can be used as a signal path between the first die and the another component, to implement signal interworking between the first die and the another component.

In an optional implementation, a vertical projection of the first middle-layer via on the third die overlaps a position of the first lower-layer via. For example, when both the first lower-layer via and the first middle-layer via are through silicon vias, the first lower-layer via and the first middle-layer via may be coaxially disposed, and diameters of the first lower-layer via and the first middle-layer via are the same or approximately the same. In this way, a pattern that is of a mask for preparing the first middle-layer via and that corresponds to a position of the first middle-layer via may be the same as a pattern that is of a mask for preparing the first lower-layer via and that corresponds to a position of the first lower-layer via, so that a pattern difference between different masks is reduced, and difficulty in preparing the masks is reduced.

In an optional implementation, the first conductive structure further includes a first upper-layer via, and the first upper-layer via penetrates through the first die. Another die stacked on the first die may be electrically connected to another die or component through the first conductive structure. A vertical projection of the first upper-layer via on the third die overlaps a position of the first lower-layer via. In this way, when both the first upper-layer via and the first lower-layer via are through silicon vias, the first upper-layer via may be coaxially disposed with the first middle-layer via and the first lower-layer via, and diameters of the first upper-layer via, the first middle-layer via, and the first lower-layer via are the same or approximately the same. In this way, a pattern difference between a mask for preparing the first upper-layer via and the mask for preparing the first middle-layer via can be reduced, and difficulty in preparing the masks can be reduced.

In an optional implementation, the second conductive structure includes a second lower-layer via, the second lower-layer via penetrates through the third die, and one end of the second lower-layer via is electrically connected to the second redistribution layer. In this way, the second lower-layer via in the second conductive structure may electrically connect the second interface circuit of the second die to another component, so that the second conductive structure can be used as a signal path between the second die and the another component, to implement signal interworking between the second die and the another component.

In an optional implementation, the second conductive structure further includes a second middle-layer via and a second upper-layer via. The second middle-layer via penetrates through the second die, and a vertical projection of the second middle-layer via on the third die overlaps a position of the second lower-layer via. The second upper-layer via penetrates through the first die, and a vertical projection of the second upper-layer via on the third die overlaps the position of the second lower-layer via. When the first lower-layer via, the second middle-layer via, and the second upper-layer via are all through silicon vias, the second upper-layer via may be coaxially disposed with the second middle-layer via and the second lower-layer via, and diameters of the second upper-layer via, the second middle-layer via, and the second lower-layer via are the same or approximately the same. In this way, a pattern difference between a mask for preparing the second upper-layer via, a mask for preparing the second middle-layer via, and a mask for preparing the second lower-layer via can be reduced, and difficulty in preparing the masks can be reduced.

In an optional implementation, the first die, the second die, and the third die are storage dies. The chip stacking structure further includes a logic die, and the logic die is disposed on the carrier board. The logic die includes a first logic interface component and a second logic interface component. The first logic interface component is electrically connected to the first conductive structure, and the second logic interface component is electrically connected to the second conductive structure. In this way, a first logic interface circuit of the logic die is electrically connected to the first interface circuit of the first die through the first conductive structure, and the first logic interface circuit may be further electrically connected to another chip, for example, a processing chip. A second logic interface circuit of the logic die may be electrically connected to the second interface circuit of the second die through the second conductive structure, and the second logic interface circuit may be further electrically connected to the processing chip. When a signal is transmitted between the storage die and the processing chip, the signal is first processed by the logic die.

In an optional implementation, the logic die is disposed between the third die and the carrier board. The first conductive structure includes the first middle-layer via and the first lower-layer via. The first middle-layer via penetrates through the first die, and two ends of the first middle-layer via are electrically connected to the first redistribution layer and the first lower-layer via respectively; and the first lower-layer via penetrates through the third die. The first conductive structure further includes a first logic via that penetrates through the logic die, and two ends of the first logic via are electrically connected to the first lower-layer via and the first logic interface component respectively. It can be learned from the foregoing that, in one aspect, an upper end of the first logic via is electrically connected to a lower end of the first lower-layer via, the first lower-layer via penetrates through the third die, and an upper end of the first lower-layer via is electrically connected to a lower end of the first middle-layer via. An upper end of the first middle-layer via is electrically connected to the first interface circuit of the first die. In another aspect, a part of a metal pattern layer at a logic redistribution layer and the first logic interface component form the first logic interface circuit of the logic die. A lower end of the first logic via is electrically connected to the first logic interface component through the logic redistribution layer, that is, the lower end of the first logic via is electrically connected to the first logic interface circuit of the logic die. In this way, the first logic interface circuit of the logic die may be electrically connected to the first interface circuit of the first die through the first conductive structure.

In an optional implementation, a vertical projection of the first lower-layer via on the logic die overlaps a position of the first logic via. Similarly, when both the first lower-layer via and the first logic via are through silicon vias, the first lower-layer via and the first logic via may be coaxially disposed, and diameters of the first lower-layer via and the first logic via are the same or approximately the same. In this way, a pattern difference between the mask for preparing the first lower-layer via and a mask for preparing the first logic via can be reduced, and difficulty in preparing the masks can be reduced.

In an optional implementation, the logic die is disposed between the third die and the carrier board, so that a plurality of stacked chips can form a 3D integrated structure. In addition, the second conductive structure includes the second lower-layer via that penetrates through the third die, and the one end of the second lower-layer via is electrically connected to the second redistribution layer. The second conductive structure further includes a second logic via that penetrates through the logic die, and two ends of the second logic via are electrically connected to the other end of the second lower-layer via and the second logic interface component respectively. It can be learned from the foregoing that, in one aspect, an upper end of the second logic via is electrically connected to a lower end of the second lower-layer via, the second lower-layer via penetrates through the third die, and an upper end of the second lower-layer via is electrically connected to the second interface circuit of the second die. In another aspect, the second logic interface component and a part of the metal pattern layer at the logic redistribution layer form the second logic interface circuit of the logic die. A lower end of the second logic via is electrically connected to the second logic interface component through the logic redistribution layer, that is, the lower end of the second logic via is electrically connected to the second logic interface circuit of the logic die. In this way, the second logic interface circuit of the logic die may be electrically connected to the first interface circuit of the second die through the second conductive structure.

In an optional implementation, a vertical projection of the second lower-layer via on the logic die overlaps a position of the second logic via. Similarly, when both the second lower-layer via and the second logic via are through silicon vias, the second lower-layer via and the second logic via may be coaxially disposed, and diameters of the second lower-layer via and the second logic via are the same or approximately the same. In this way, a pattern difference between the mask for preparing the second lower-layer via and a mask for preparing the second logic via can be reduced, and difficulty in preparing the masks can be reduced.

In an optional implementation, the third die includes a third interface component. The logic die is disposed between the third die and the carrier board, and the logic die further includes a third logic interface component. The chip stacking structure further includes a third conductive structure and a third redistribution layer. The third conductive structure penetrates through at least the logic die, and the third conductive structure is electrically connected to the third logic interface component. In addition, the third conductive structure is insulated from the first redistribution layer and the second redistribution layer. The third redistribution layer is disposed on an active surface of the third die, is electrically connected to the third interface component and the third conductive structure, and is insulated from the first conductive structure and the second conductive structure. In this way, the third logic interface component and at least a part of the logic redistribution layer that is located on an active surface of the logic die may form a third logic interface circuit of the logic die. The third logic interface circuit of the logic die may be electrically connected to a third interface circuit of the third die through the third conductive structure, and the third interface circuit of the third die is insulated from the first interface circuit of the first die and the second interface circuit of the second die.

In an optional implementation, the third conductive structure includes a third logic via, the third logic via penetrates through the logic die, and two ends of the third logic via are electrically connected to the third redistribution layer and the third logic interface component respectively. In this case, one end of the third logic via may be electrically connected to the third interface component of the third die through the third redistribution layer, so that an upper end of the third logic via is electrically connected to the third interface circuit of the third die. In addition, the other end of the third logic via may be electrically connected to the third logic interface component through the logic redistribution layer, so that a lower end of the third logic via is electrically connected to the third logic interface circuit of the logic die. In this way, the third interface circuit of the third die may be electrically connected to the third logic interface circuit of the logic die through the third conductive structure.

In an optional implementation, the third conductive structure further includes a third lower-layer via, a third middle-layer via, and a third upper-layer via. The third lower-layer via penetrates through the third die, and a vertical projection of the third lower-layer via on the logic die overlaps a position of the third logic via. The third middle-layer via penetrates through the second die, and a vertical projection of the third middle-layer via on the third die overlaps a position of the third lower-layer via. The third upper-layer via penetrates through the first die, and a vertical projection of the third upper-layer via on the third die overlaps the position of the third lower-layer via. Similarly, when the third lower-layer via, the third middle-layer via, and the third logic via are all through silicon vias, the third lower-layer via, the third middle-layer via, and the third logic via may be coaxially disposed, and diameters of the third lower-layer via, the third middle-layer via, and the third logic via are the same or approximately the same. In this way, a pattern difference between a mask for preparing the third lower-layer via, a mask for preparing the third middle-layer via, and a mask for preparing the third logic via can be reduced, and difficulty in preparing the masks can be reduced.

In an optional implementation, the logic die is disposed between the third die and the carrier board, and the logic die further includes a fourth logic interface component. The chip stacking structure further includes a fourth die, a fourth conductive structure, and a fourth redistribution layer. The fourth die is disposed on a side that is of the first die and that is away from the second die, and includes a fourth interface component. The fourth conductive structure penetrates through at least the first die, the second die, and the third die, and the fourth conductive structure is electrically connected to the fourth logic interface component. The fourth conductive structure is insulated from the first redistribution layer and the second redistribution layer. The fourth redistribution layer is disposed on an active surface of the fourth die, is electrically connected to the fourth interface component and the fourth conductive structure, and is insulated from the first conductive structure and the second conductive structure. The fourth interface component and at least a part of a metal line structure at the fourth redistribution layer may form a fourth interface circuit of the fourth die. The fourth logic interface component and a part of the logic redistribution layer may form a fourth logic interface circuit of the logic die. In this way, the fourth interface circuit that is of the fourth die and that includes the fourth redistribution layer and the fourth interface component may be electrically connected to the fourth logic interface circuit of the logic die through the fourth conductive structure, to implement signal interworking between the fourth die and the logic die. In addition, a metal pattern at the fourth redistribution layer only needs to be electrically connected to the fourth interface component and the fourth conductive structure, so that the fourth interface circuit that is of the fourth die and that includes the fourth redistribution layer and the fourth interface component is electrically connected to the fourth conductive structure. The fourth conductive structure does not need to be electrically connected to the first interface circuit of the first die, the second interface circuit of the second die, and the third interface circuit of the third die. The fourth interface circuit and the fourth conductive structure of the fourth die may form an independent signal path of the fourth die.

In an optional implementation, the fourth conductive structure includes a fourth upper-layer via, a fourth middle-layer via, a fourth lower-layer via, and a fourth logic via. The fourth upper-layer via penetrates through the first die, and one end of the fourth upper-layer via is electrically connected to the fourth redistribution layer. The fourth middle-layer via penetrates through the second die, and one end of the fourth middle-layer via is electrically connected to the other end of the fourth upper-layer via. The fourth lower-layer via penetrates through the third die, and one end of the fourth lower-layer via is electrically connected to the other end of the fourth middle-layer via. The fourth logic via penetrates through the logic die, and two ends of the fourth logic via are electrically connected to the other end of the fourth lower-layer via and the fourth logic interface component respectively. A vertical projection of the fourth upper-layer via on the logic die, a vertical projection of the fourth middle-layer via on the logic die, and a vertical projection of the fourth lower-layer via on the logic die overlap a position of the fourth logic via. Similarly, when the fourth upper-layer via, the fourth middle-layer via, the fourth lower-layer via, and the fourth logic via are all through silicon vias, the fourth upper-layer via, the fourth middle-layer via, the fourth lower-layer via, and the fourth logic via may be coaxially disposed, and diameters of the fourth upper-layer via, the fourth middle-layer via, the fourth lower-layer via, and the fourth logic via are the same or approximately the same. In this way, a pattern difference between a mask for preparing the fourth upper-layer via, a mask for preparing the fourth middle-layer via, a mask for preparing the fourth lower-layer via, and a mask for preparing the fourth logic via can be reduced, and difficulty in preparing the masks can be reduced.

According to an aspect of this application, an electronic device is provided, including a printed circuit board and the chip stacking structure described above. The chip stacking structure is disposed on the printed circuit board and is electrically connected to the printed circuit board. The electronic device has a same technical effect as the chip stacking structure provided in the foregoing embodiment. Details are not described herein again.

### BRIEF DESCRIPTION OF DRAWINGS

FIG. 1 is a diagram of a structure of an electronic device according to an embodiment of this application;
FIG. 2 is a diagram of a structure of a chip stacking structure in FIG. 1;
FIG. 3 is a diagram of a structure of a redistribution layer located on an active surface of a die according to an embodiment of this application;
FIG. 4A is a diagram of a structure of a chip stacking structure in a related technology;
FIG. 4B is a diagram of connection of interface circuits of a single die in the chip stacking structure shown in FIG. 4A;
FIG. 5A is a diagram of another structure of a chip stacking structure in FIG. 1;
FIG. 5B is a diagram of another structure of a chip stacking structure in FIG. 1;
FIG. 6A is a diagram of another structure of a chip stacking structure in FIG. 1;
FIG. 6B is a diagram of another structure of a chip stacking structure in FIG. 1;
FIG. 7 is a diagram of another structure of a chip stacking structure in FIG. 1;
FIG. 8A is a diagram of another structure of a chip stacking structure in FIG. 1;
FIG. 8B is a diagram of a bottom view of a structure obtained in a direction Z in FIG. 8A;
FIG. 9 is a diagram of another structure of a chip stacking structure in FIG. 1;
FIG. 10 is a diagram of another structure of a chip stacking structure in FIG. 1;
FIG. 11A is a diagram of another structure of a chip stacking structure in FIG. 1; and
FIG. 11B is a diagram of a bottom view of a structure obtained in a direction Z in FIG. 11A.

### Reference numerals:

01: electronic device; 10: PCB; 11: solder ball; 20: chip stacking structure; 12: carrier board; 200: stack body; 201: first die; 202: second die; 203: third die; 301: first interface component; 302: second interface component; 303: third interface component; 41: first redistribution layer; 42: second redistribution layer; 43: third redistribution layer; 51: first conductive structure; 52: second conductive structure; 100: dielectric layer; 101: metal pattern layer; 102: metal columnar structure; 110: chip; 111: redistribution layer; 114: interface component; 112: interface circuit; 113: vertical interconnection structure; 115: I/O port; 511: first lower-layer via; 512: first middle-layer via; 521: second lower-layer via; 60: logic die; 522: second middle-layer via; 71: power supply TSV; 72: dummy TSV; 61: logic redistribution layer; 610: first logic via; 620: second logic via; 53: third conductive structure; 630: second logic via; 601: first logic interface component; 602: second logic interface component; 603: third logic interface component; 531: third lower-layer via; 532: third middle-layer via; 513: first upper-layer via; 523: second upper-layer via; 533: third upper-layer via; 204: fourth die; 44: fourth redistribution layer; 304: fourth interface component; 54: fourth conductive structure; 541: fourth lower-layer via; 542: fourth middle-layer via; 543: fourth upper-layer via; and 604: fourth logic interface component.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Terms such as "first" and "second" below are merely used for ease of description, and shall not be understood as indicating or implying relative importance or implicitly indicating a quantity of indicated technical features. Therefore, a feature limited by "first", "second", or the like may explicitly or implicitly include one or more features. In the descriptions of this application, unless otherwise stated, "a plurality of" means two or more than two.

In addition, in embodiments of this application, orientation terms such as "upper", "lower", "left", "right", "horizontal", and "vertical" may include but are not limited to definitions based on illustrated orientations in which components in the accompanying drawings are placed. It should be understood that, these directional terms may be relative concepts used for relative description and clarification, and may change accordingly depending on a change in the orientations in which the components are placed in the accompanying drawings.

In this application, unless otherwise clearly specified and limited, a term "connection" should be understood in a broad sense. For example, the "connection" may be a fixed mechanical connection, or may be a detachable mechanical connection or an integrated connection, or the "connection" may be a direct connection, or may be an indirect connection implemented through an intermediate medium.

In addition, unless otherwise expressly specified and limited, a term "electrical connection" should be understood in a broad sense. For example, the "electrical connection" may be a direct electrical connection, for example, two components are physically in contact and electrically connected; or may be understood as that different components in a line structure are electrically connected through a physical line that can transmit an electrical signal, for example, a printed circuit board (printed circuit board, PCB), copper foil, or a conducting wire, to transmit an electrical signal. Alternatively, the "electrical connection" may be an indirect electrical connection between two components through an intermediate medium. Alternatively, the "electrical connection" may be an electrical connection between two components in a separated or non-contact manner, for example, two components are electrically connected in a capacitive coupling manner, to transmit an electrical signal.

In this application, that two components are "parallel" to each other may be that the two components are completely parallel, or may be that the two components are approximately parallel within an acceptable deviation range. In addition, that two components are "perpendicular" to each other may be that the two components are completely perpendicular, or may be that the two components are approximately perpendicular within an acceptable deviation range. The acceptable deviation range may be determined by a limitation of a measurement system used by a person of ordinary skill in the art.

It should be noted that, in the accompanying drawings of embodiments of this application, an assembly is represented by using a guide line with an arrow, and a component is represented by using only a guide line.

An embodiment of this application provides an electronic device. The electronic device may be applied to various communication systems or communication protocols, for example, a global system for mobile communications (global system of mobile communication, GSM), a code division multiple access (code division multiple access, CDMA) system, wideband code division multiple access (wideband code division multiple access wireless, WCDMA), a general packet radio service (general packet radio service, GPRS), and long term evolution (long term evolution, LTE). The electronic device may include an electronic product like a server, a computer, a portable android device (portable android device, Pad), a notebook computer, a vehicle-mounted computer, a graphics card (graphics card), a solid-state drive (solid-state drive, SSD), a flash drive (USB flash drive), or a mobile phone. A specific form of the electronic device is not particularly limited in embodiments of this application.

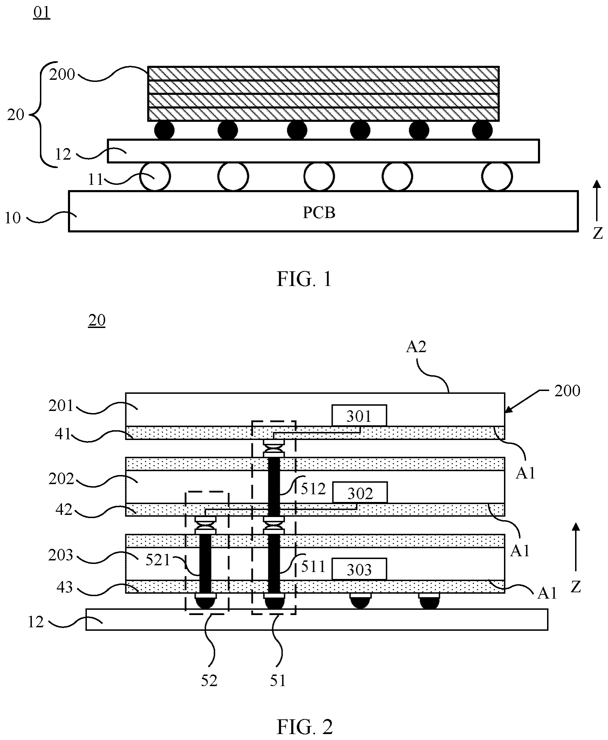

In some embodiments of this application, as shown in FIG. 1, the electronic device 01 may include a printed circuit board PCB 10 and at least one chip stacking structure 20 disposed on the PCB 10. A connection structure, for example, a solder ball 11, is disposed at the bottom of the chip stacking structure 20. The chip stacking structure 20 may be welded to a pad (pad) of the PCB 10 by using the solder ball 11, so that the chip stacking structure 20 is electrically connected to the PCB 10, to implement signal interworking.

For example, the chip stacking structure 20 may include a processing chip. For example, the processing chip includes but is not limited to a central processing unit (central processing unit, CPU), a graphics processing unit (graphics processing unit, GPU), a system on chip (system on chip, SOC), or the like. Alternatively, for another example, the chip stacking structure 20 may further include a storage chip. For example, the storage chip includes but is not limited to a stacked dynamic random access memory (stacked dynamic random access memory, stacked DRAM), a high-bandwidth memory (high-bandwidth memory, HBM), or the like. A type of the chip stacking structure 20 is not limited in embodiments of this application. For ease of description, the following uses an example in which the chip stacking structure 20 is the foregoing storage chip for description.

In addition, the electronic device 01 may further include an interface for external memory, a universal serial bus (universal serial bus, USB) interface, a power management module, an antenna, a mobile communication module, a wireless communication module, an audio module, a speaker, a receiver, a microphone, a headset jack, a sensor module, a button, and a camera..

The following describes a structure of the chip stacking structure 20 by using an example. In some embodiments of this application, as shown in FIG. 1, the chip stacking structure 20 may include a carrier board 12 and at least one stack body 200 disposed on the carrier board 12. The stack body 200 may include a plurality of dies (die) that are stacked in a first direction Z, and the plurality of dies may be parallel or approximately parallel to each other. The stack body 200 is electrically connected to the PCB 10 through the carrier board 12. The first direction Z may be a direction perpendicular to a carrier surface of the carrier board 12, namely, a thickness direction of the dies in the stack body 200.

The carrier board 12 may be a package substrate, and the carrier board 12 may include an insulated dielectric layer (dielectric layer) and a metal wiring disposed at the dielectric layer. An electrical connection structure, for example, the solder ball or a micro bump (bump), may be disposed on a side that is of the stack body 200 and that is close to the carrier board 12, so that the stack body 200 may be electrically connected to the PCB 10 through the metal wiring inside the carrier board 12.

In addition, in some other embodiments of this application, the chip stacking structure 20 may further include a shielding can and a heat dissipating lid (not shown in the figure). The shielding can may be disposed around the stack body 200, to reduce electromagnetic interference caused by an external component to the stack body 200. The heat dissipating lid may be disposed on the top of the stack body 200 to dissipate heat of the stack body 200.

The following describes a connection manner of the dies in the stack body 200 of the chip stacking structure 20 by using an example. For example, as shown in FIG. 2, the stack body 200 may include a first die 201, a second die 202, and a third die 203. When the chip stacking structure 20 is the storage chip, the die may be a storage die.

For example, the storage die may be a volatile memory chip, for example, a DRAM, or a static random access memory (static random access memory, SRAM) chip. Alternatively, for another example, the storage die may be a nonvolatile memory semiconductor chip, for example, a phase change random access memory (phase change random access memory, PRAM) chip, a magnetoresistive random access memory (magnetoresistive random access memory, MRAM) chip, a ferroelectric random access memory (ferroelectric random access memory, FeRAM) chip, or a resistive random access memory (resistive random access memory, ReRAM) chip. A type of the storage die is not limited in this application.

The first die 201 may be disposed on the carrier board 12, and the first die 201 includes a first interface component 301. The second die 202 is disposed between the carrier board 12 and the first die 201, and the second die 202 includes a second interface component 302. The third die 203 may be disposed between the carrier board 12 and the second die 202, and the third die 203 may include a third interface component 303. In this case, the first die 201, the second die 202, and the third die 203 may be sequentially stacked close to the carrier board 21 in the first direction Z.

On this basis, to electrically connect active components in the die to form a circuit structure having a specific function, for example, an interface circuit, the chip stacking structure 20 may further include a first redistribution layer (redistribution layer, RDL) 41 and a second redistribution layer 42 shown in FIG. 2. The first redistribution layer 41 may be disposed on an active surface (active surface) A1 of the first die 201, and the first redistribution layer 41 is electrically connected to the first interface component 301. In addition, the second redistribution layer 42 is disposed on an active surface A1 of the second die 202, and the second redistribution layer 42 is electrically connected to the second interface component 302.

The following describes manufacturing processes of an interface component and a redistribution layer of the die by using an example. In some embodiments of this application, a manufacturing process of a die (for example, the first die 201) may include a front end of line (front end of line, FEOL) process and a back end of line (back end of line, BEOL) process.

The FEOL process means that a plurality of active components (active device), for example, transistors, are prepared in a preset area on a surface of a wafer (wafer) by using a process like ion implantation. A part of the plurality of active components may be used as an interface component in the die, for example, the first interface component 301 in the first die 201. A surface that is of the die and that has the active component is an active surface A1, and a surface disposed opposite to the active surface A1 may be referred to as a passive surface A2.

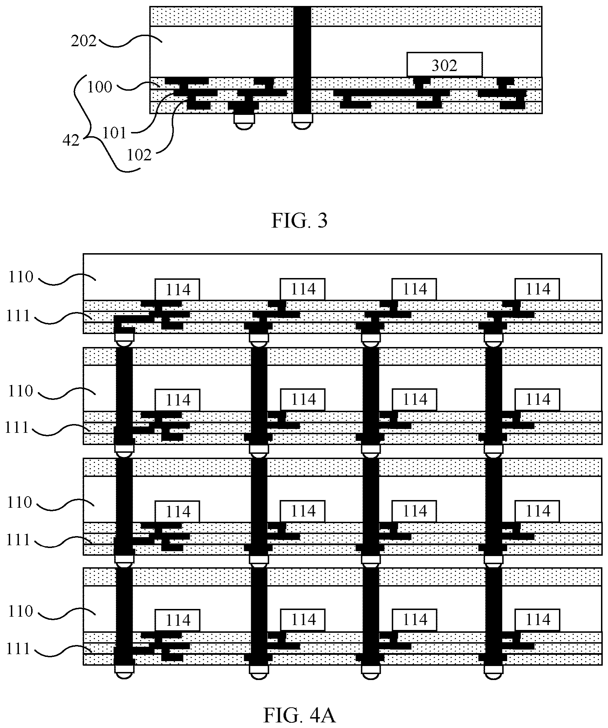

Next, when the BEOL process is performed, a plurality of dielectric layers 100, a plurality of metal pattern layers 101 at the dielectric layers 100, and metal columns 102 that penetrate through the dielectric layers shown in FIG. 3 may be manufactured on a surface of the die, for example, the active surface A1, to form the redistribution layer (for example, the first redistribution layer 41). For example, a material like silicon dioxide may be deposited on the active surface A1 of the first die 201 by using a plasma enhanced chemical vapor deposition (plasma enhanced chemical vapor deposition, PECVD) method, to form the dielectric layers 100. A plurality of metal pattern layers 101 and metal columns 102 with patterns are formed at the dielectric layers 100 by using deposition and etching processes. Two adjacent metal pattern layers 101 are electrically connected through a metal columnar structure 102. The metal pattern layer 101 and the metal columnar structure 102 may be used as metal line structures at the redistribution layer.

The foregoing is described by using an example in which the active surface A1 of the die has the redistribution layer. In some other embodiments, a redistribution layer may also be disposed on the passive surface A2 of the die, for example, a die located in a middle position in the plurality of stacked dies. For example, a redistribution layer (represented by a dot pattern in the figure) may be disposed on both an active surface A1 and a passive surface A2 of the second die 202 in FIG. 2.

It can be learned from the foregoing that, as shown in FIG. 2, the first redistribution layer 41 located on the active surface A1 of the first die 201 is electrically connected to the first interface component 301 of the first die 201. Therefore, at least a part of the metal line structure at the first redistribution layer 41 and the first interface component 301 may form a first interface circuit of the first die 201. The interface circuit may also be referred to as an input/output (input/output, I/O) circuit. The interface circuit is configured to process a signal input to the first die 201 and a signal output by the first die 201.

For example, when the first die 201 is a storage die, the first interface circuit may perform data conversion on the signal input to the first die 201, for example, convert serial data into parallel data, to implement data decoding, address selection, frequency reduction processing, or the like. Alternatively, the first interface circuit may further amplify the signal output by the first die 201. In addition, in addition to modules configured to implement the foregoing functions, the first interface circuit may further include an electrostatic discharge (electro static discharge, ESD) module and a latch, for example, a DFF.

Similarly, the second redistribution layer 42 located on the active surface A1 of the second die 202 is electrically connected to the second interface component 302 of the second die 202. Therefore, at least a part of a metal line structure at the second redistribution layer 42 and the second interface component 302 may form a second interface circuit of the second die 202. A function of the second interface circuit is the same as that described above, and details are not described herein again.

In some embodiments of this application, still as shown in FIG. 2, the third die 203 may include a third interface component 303, and the chip stacking structure 20 may further include a third redistribution layer 43 disposed on an active surface A1 of the third die 203. Similarly, the third redistribution layer 43 may be electrically connected to the third interface component 303 of the third die 203. Therefore, the third interface component 303 and at least a part of a metal line structure at the third redistribution layer 43 may form a third interface circuit of the third die 203. A function of the third interface circuit is the same as that described above, and details are not described herein again.

It should be noted that the foregoing is merely an example for describing a function of an interface circuit, and does not constitute a limitation on the interface circuit. Any circuit structure on the die that is used to process an input or output signal falls within the protection scope of the interface circuit in this application. In addition, for ease of description, in the following related accompanying drawings, the first interface component 301, the second interface component 302, and the third interface component 303 are simplified as rectangular frames. The foregoing illustrated manner merely indicates that an interface component exists in a corresponding die, and does not constitute a limitation on a position and an occupied area of the interface component.

On this basis, to implement signal interworking between different dies in the chip stacking structure 20, between the chip stacking structure 20 and another chip, or between the chip stacking structure 20, the carrier board 12, and the PCB 10, as shown in FIG. 2, the chip stacking structure 20 may further include a first conductive structure 51 and a second conductive structure 52. The first conductive structure 51 may penetrate through at least the second die 202 and the third die 203. The second conductive structure 52 penetrates through at least the third die 203.

For example, a conductive structure in embodiments of this application, for example, the first conductive structure 51 or the second conductive structure 52, may be a via (Via) that perpendicularly or approximately perpendicularly penetrates through at least one die in a stacking direction (namely, the first direction Z) of the dies. A through silicon via (through silicon via, TSV) technology may be used for the via to penetrate through an upper surface and a lower surface of the die to form a through via, and then the through via is filled with a conductive material, for example, copper, tungsten, or polycrystalline silicon. In addition, a pad (pad) may be disposed at two ends of the via, and a micro bump (µbump) is disposed on upper and lower pads between adjacent dies, so that signal interworking between the two adjacent dies can be implemented. In addition, a gap between the adjacent dies may be insulated and isolated by using an organic filler.

In conclusion, the first redistribution layer 41 is electrically connected to both the first interface component 301 and the first conductive structure 51, so that the first interface component 301 and a part of the first redistribution layer 41 can form the first interface circuit of the first die 201. In addition, the first interface circuit is electrically connected to the first conductive structure 51, so that the first die 201 can implement signal interworking with another component through the first interface circuit and the first conductive structure 51.

Similarly, the second redistribution layer 42 is electrically connected to the second interface component 302 and the second conductive structure 52, so that the second interface component 302 and a part of the second redistribution layer 42 can form the second interface circuit of the second die 202. In addition, the second interface circuit is electrically connected to the second conductive structure 52, so that the second die 202 can implement signal interworking with another component through the second interface circuit and the second conductive structure 52.

Similarly, the third redistribution layer 43 is electrically connected to the third interface component 303 and the second conductive structure 52, so that the third interface component 303 and a part of the third redistribution layer 43 can form the third interface circuit of the third die 203.

In addition, the first redistribution layer 41 is electrically connected to the first conductive structure 51, and the first redistribution layer 41 is insulated from the second conductive structure 52; and the second redistribution layer 42 is electrically connected to the second conductive structure 52, and the second redistribution layer 42 is insulated from the first conductive structure 51, so that the first conductive structure 51 can be insulated from the second conductive structure 52. In addition, the third redistribution layer 43 is insulated from the first conductive structure 51 and the second conductive structure 52.

In this case, the first redistribution layer 41, the second redistribution layer 42, and the third redistribution layer 43 may be disposed in a heterogeneous manner. To be specific, the metal pattern layer 101 at the first redistribution layer 41 (as shown in FIG. 3), a metal pattern layer at the second redistribution layer 42, and a metal pattern layer at the third redistribution layer 43 may be prepared by using different masks (mask), so that patterns of the metal pattern layer 101 at the first redistribution layer 41, the metal pattern layer at the second redistribution layer 42, and the metal pattern layer at the third redistribution layer 43 are different.

In this case, the metal pattern layer 101 at the first redistribution layer 41 only needs to electrically connect the first interface component 301 to the first conductive structure 51, so that the first interface circuit that is of the first die 201 and that includes the first redistribution layer 41 and the first interface component 301 is electrically connected to the first conductive structure 51, and the first interface circuit does not need to be electrically connected to the second interface circuit of the second die 202 (including the second interface component 302 and the part of the second redistribution layer 42). Similarly, the metal pattern layer at the second redistribution layer 42 only needs to electrically connect the second interface component 302 to the second conductive structure 52, so that the second interface circuit that is of the second die 202 and that includes the second redistribution layer 42 and the second interface component 302 is electrically connected to the second conductive structure 52, and the second interface circuit does not need to be electrically connected to the first interface circuit of the first die 201 (including the first interface component 301 and the part of the first redistribution layer 41).

Similarly, the metal pattern layer at the third redistribution layer 43 only needs to be electrically connected to the third interface component 303, so that the third interface component 303 and the part of the third redistribution layer 43 form the third interface circuit of the third die 203. The third interface circuit does not need to be electrically connected to the first interface circuit of the first die 201 and the second interface circuit of the second die 202.

In this way, the first interface circuit of the first die 201, the second interface circuit of the second die 202, and the third interface circuit of the third die 203 are insulated from each other, so that when the first die 201, the second die 202, and the third die 203 are simultaneously in an operating state, the first interface circuit of the first die 201 and the second interface circuit of the second die 202 can independently transmit a signal to another component through the first conductive structure 51 and the second conductive structure 52 respectively. The first interface circuit and the first conductive structure 51 form a signal path of the first die 201, and the signal path may be electrically connected to one 1-bit I/O port of the chip stacking structure 20. Similarly, the second interface circuit and the second conductive structure 52 form a signal path of the second die 202, and the signal path may be electrically connected to one 1-bit I/O port of the chip stacking structure.

For example, the chip stacking structure 20 in embodiments of this application may have eight channels (channel) to be electrically connected to another chip, for example, a CPU. Each channel has a 128-bit width (that is, has 128 1-bit I/O ports), and has a total of 1024-bit width.

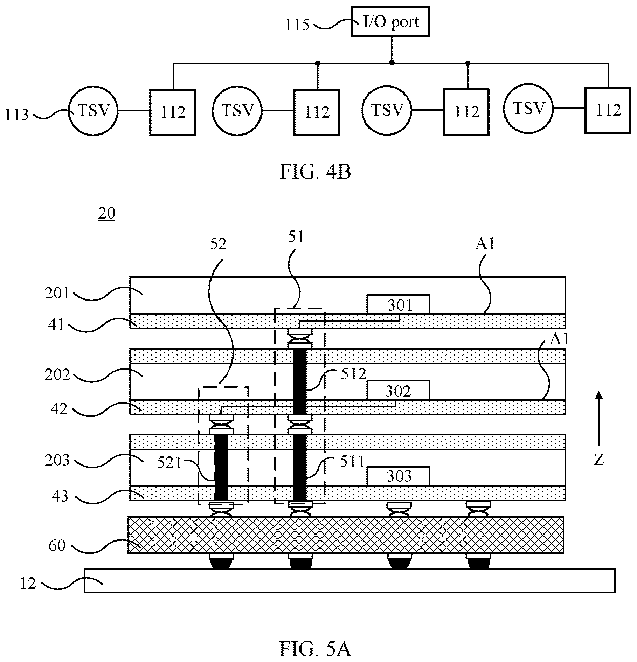

As shown in FIG. 4A, redistribution layers 111 on active surfaces of any two chips 110 in chips stacked in a related technology (for example, four chips are stacked in FIG. 4A) are manufactured by using a same mask, that is, homogeneously designed. In this case, patterns of metal pattern layers located at a same layer in the redistribution layers 111 are completely consistent. To enable each chip 110 to operate independently, a plurality of groups of interface components 114 need to be disposed in each chip 110. Each group of interface components 114 and a part of metal lines at the redistribution layer 111 may form an interface circuit 112 shown in FIG. 4B.

In this way, as shown in FIG. 4B, one 1-bit I/O port 115 in the chip stacking structure needs to be connected to a plurality of interface circuits 112, and each interface circuit 112 is electrically connected to one vertical interconnection structure 113 (for example, a TSV). Therefore, one 1-bit I/O port 115 has a plurality of signal transmission paths. Based on this, when each chip 110 is in an operating state, one interface circuit 112 connected to one 1-bit I/O port 115 needs to be controlled, through circuit control, to be in an operating state (represented by a solid line in FIG. 4B), and remaining interface circuits 112 are in a non-operating state (represented by dashed lines in FIG. 4B). In this case, the remaining interface circuits 112 are not effectively used in actual operating, and therefore become a redundancy design. As a result, a plane dimension of the chip is increased.

Therefore, in comparison with the foregoing homogeneous design solution shown in FIG. 4A and FIG. 4B, in this application, the first redistribution layer 41 and the second redistribution layer 42 shown in FIG. 2 are heterogeneously designed. In a single die (for example, the first die 201, the second die 202, or the third die 203), only an interface component required by one interface circuit needs to be disposed, so that one 1-bit I/O port of the chip stacking structure 20 only needs to be electrically connected to one interface circuit of the die, to reduce a quantity of interface circuits of each die, and reduce a plane dimension of the chip stacking structure.

It should be noted that a quantity of stacked dies in the chip stacking structure 20 is not limited in this application. The foregoing is merely described by using an example in which the chip stacking structure 20 includes three dies, namely, the first die 201, the second die 202, and the third die 203. When the chip stacking structure 20 includes more than three dies, a manner of disposing any three dies in the chip stacking structure 20 is the same as the disposing manner in the solution provided in embodiments of this application, and falls within the protection scope of this application.

It can be learned from the foregoing that, in the chip stacking structure 20 provided in embodiments of this application, to insulate the first interface circuit of the first die 201 from the second interface circuit of the second die 202, as shown in FIG. 5A, the first interface circuit of the first die 201 and the second interface circuit of the second die 202 can independently transmit a signal to another component through the first conductive structure 51 and the second conductive structure 52 respectively. The following describes a manner of disposing the first conductive structure 51 and the second conductive structure 52 by using an example.

For example, when the chip stacking structure 20 includes the first die 201, the second die 202, and the third die 203 that are stacked on the carrier board 12, as shown in FIG. 5A, the first conductive structure 51 may include a first lower-layer via 511 and a first middle-layer via 512. The first middle-layer via 512 may penetrate through the second die 202. In addition, one end (for example, an upper end) of the first middle-layer via 512 is electrically connected to the first redistribution layer 41 located on the active surface A1 of the first die 201.

The first lower-layer via 511 may penetrate through the third die 203. One end (for example, an upper end) of the first lower-layer via 511 is electrically connected to the other end (for example, a lower end) of the first middle-layer via 512. In addition, when the first die 201, the second die 202, and the third die 203 are storage dies, to enable a signal to be transmitted between each storage die and the processing chip, for example, the CPU, in the electronic device 01, the chip stacking structure 20 may further include a logic die 60 shown in FIG. 5A.

The logic die 60 is disposed on the carrier board 12, and is electrically connected to the first die 201, the second die 202, the third die 203, and the carrier board 12. In this way, when a signal is transmitted between the storage die and the processing chip, the signal is first processed by the logic die 60. For example, the logic die 60 may perform data conversion on a signal from the processing chip, for example, convert serial data into parallel data, and then send the parallel data to each storage die; or convert parallel data from the storage die into serial data, and then send the serial data to the processing chip.

Based on this, in some embodiments of this application, as shown in FIG. 5A, the logic die 60 may be located between the third die 203 and the carrier board 12, to form a 3D integrated structure together with the plurality of stacked storage chips. In this case, the other end (for example, a lower end) of the first lower-layer via 511 may be indirectly electrically connected to the carrier board 12 through the logic die 60.

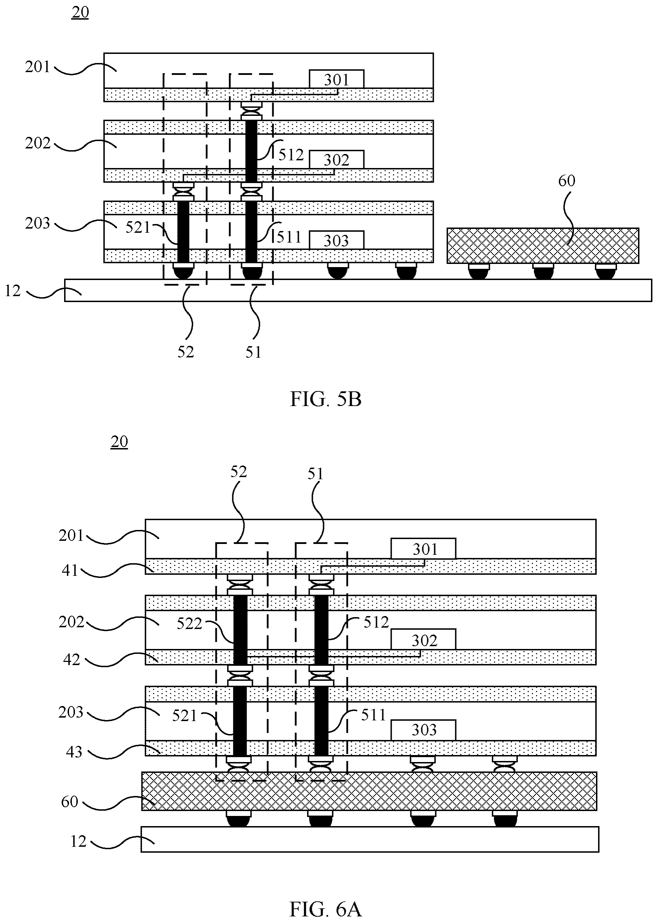

Alternatively, in some other embodiments of this application, as shown in FIG. 5B, the logic die 60 may be located on a side of the plurality of stacked storage dies (for example, the first die 201, the second die 202, and the third die 203), to form a 2.5D integrated structure together with the plurality of stacked storage chips. In this case, the other end (for example, a lower end) of the first lower-layer via 511 may be directly electrically connected to the carrier board 12. A manner of disposing the logic die 60 on the carrier board 12 is not limited in this application. For ease of description, the following uses an example in which the 3D integration manner shown in FIG. 5A is used for the logic die 60 and the storage chip for description.

In this way, still as shown in FIG. 5A, the first lower-layer via 511 and the first middle-layer via 512 that are electrically connected to each other in the first conductive structure 51 may electrically connect the first interface circuit (including the first interface component 301 of the first die 201 and a partial structure of the first redistribution layer 41) of the first die 201 to the logic die 60 (or the carrier board 12). Therefore, the first conductive structure 51 can be used as a signal path between the first die 201 and the logic die 60 (or the carrier board 12 shown in FIG. 5B), to implement signal interworking between the first die 201 and the logic die 60 (or the carrier board 12 shown in FIG. 5B).

For example, both the first lower-layer via 511 and the first middle-layer via 512 in the first conductive structure 51 may be TSVs. In some embodiments of this application, the first lower-layer via 511 may penetrate through the third die 203, the third redistribution layer 43 located on the active surface A1 of the third die 203, and a redistribution layer located on a passive surface of the third die 203. Similarly, the first middle-layer via 512 may penetrate through the second die 202, the second redistribution layer 42 located on the active surface A1 of the second die 202, and a redistribution layer located on the passive surface of the second die 202.

In this case, the first lower-layer via 511 and the first middle-layer via 512 may be prepared by using a via-last (Via-last) process. To be specific, an active component in a die is first prepared, then a redistribution layer is prepared, and finally the TSV is prepared. Alternatively, in some other embodiments of this application, a via-first (Via-frist) process may be used. To be specific, the TSV is prepared before an active component of a die is prepared, or after the active component is prepared and before a redistribution layer is prepared. A TSV manufacturing order is not limited in this application. In FIG. 5A or FIG. 5B, a redistribution layer located on a passive surface of a die is not marked with a number, and is represented by a rectangular frame filled with a dot pattern.

On this basis, a vertical projection of the first middle-layer via 512 on the third die 203 may overlap a position of the first lower-layer via 511. Based on this, when both the first lower-layer via 511 and the first middle-layer via 512 are TSVs, the first lower-layer via 511 and the first middle-layer via 512 may be coaxially disposed, and diameters of the first lower-layer via 511 and the first middle-layer via 512 are the same or approximately the same. In this way, a pattern that is of a mask for preparing the first middle-layer via 512 and that corresponds to a position of the first middle-layer via 512 may be the same as a pattern that is of a mask for preparing the first lower-layer via 511 and that corresponds to the position of the first lower-layer via 511, so that a pattern difference between different masks is reduced, and difficulty in preparing the masks is reduced.

In addition, still as shown in FIG. 5A, the second conductive structure 52 may include a second lower-layer via 521. The second lower-layer via 521 may penetrate through the third die 203. One end (for example, an upper end) of the second lower-layer via 521 may be electrically connected to the second redistribution layer 42 located on the active surface A1 of the second die 202. Similarly, the other end (for example, a lower end) of the second lower-layer via 521 may be indirectly electrically connected to the carrier board 12 through the logic die 60. Alternatively, as shown in FIG. 5B, the other end (for example, a lower end) of the second lower-layer via 521 may be directly electrically connected to the carrier board 12. Similarly, the second lower-layer via 521 may be a TSV, and a manufacturing method of the second lower-layer via 521 is similar to the manufacturing methods of the first lower-layer via 511 and the first middle-layer via 512. Details are not described herein again.

In this way, still as shown in FIG. 5A, the second lower-layer via 521 in the second conductive structure 52 may electrically connect the second interface circuit of the second die 202 (including the second interface component 302 of the second die 202 and a partial structure of the second redistribution layer 42) to the logic die 60 (or the carrier board 12 shown in FIG. 5B). Therefore, the second conductive structure 52 can be used as a signal path between the second die 202 and the logic die 60 (or the carrier board 12 shown in FIG. 5B), to implement signal interworking between the second die 202 and the logic die 60 (or the carrier board 12 shown in FIG. 5B).

Alternatively, in some other embodiments of this application, as shown in FIG. 6A, the second conductive structure 52 may further include a second middle-layer via 522, and the second middle-layer via 522 may penetrate through the second die 202, the second redistribution layer on the active surface of the second die 202, and the redistribution layer on the passive surface. Similarly, the second middle-layer via 522 may be a TSV, and a manufacturing method of the second middle-layer via 522 is similar to the manufacturing methods of the first lower-layer via 511 and the first middle-layer via 512. Details are not described herein again.

For example, a lower end of the second middle-layer via 522 may be electrically connected to the upper end of the second lower-layer via 521. Alternatively, for another example, a lower end of the second middle-layer via 522 may be insulated from the upper end of the second lower-layer via 521.

On this basis, a vertical projection of the second middle-layer via 522 on the third die 203 overlaps a position of the second lower-layer via 521. Similarly, when both the second lower-layer via 521 and the second middle-layer via 522 are TSVs, the second lower-layer via 521 and the second middle-layer via 522 may be coaxially disposed, and diameters of the second lower-layer via 521 and the second middle-layer via 522 are the same or approximately the same. In this way, a pattern difference between a mask for preparing the second middle-layer via 522 and a mask for preparing the second lower-layer via 521 can be reduced, and difficulty in preparing the masks can be reduced.

On this basis, as shown in FIG. 6A, when the first conductive structure 51 includes the first lower-layer via 511 and the first middle-layer via 512 that are coaxially disposed and have a same diameter or an approximately same diameter, and the second conductive structure 52 includes the second lower-layer via 521 and the second middle-layer via 522 that are coaxially disposed and have a same diameter or an approximately same diameter, the second die 202 and the third die 203 have a same structure. Therefore, the foregoing structure may be prepared in a homogeneous disposing manner.

For example, a same mask is used to prepare the active component in the second die 202, for example, the second interface component 302, and the active component in the third die 203, for example, the third interface component 303. Next, different masks may be used to prepare the second redistribution layer 42 on the active surface of the second die 202 and the third redistribution layer 43 on the active surface of the third die 203. Next, a same mask is used to prepare the first middle-layer via 512 and the second middle-layer via 522 that penetrate through the second die 202, and the first lower-layer via 511 and the second lower-layer via 521 that penetrate through the third die 203.

It can be learned from the foregoing that, different masks are used only when redistribution layers on surfaces of different dies (for example, the second die 202 and the third die 203) are prepared, and a same mask may be used for other structures such as an active component in a die and a TSV that penetrates through the die, to reduce a quantity of masks used during manufacturing, effectively simplify a manufacturing process, reduce costs, and improve productivity.

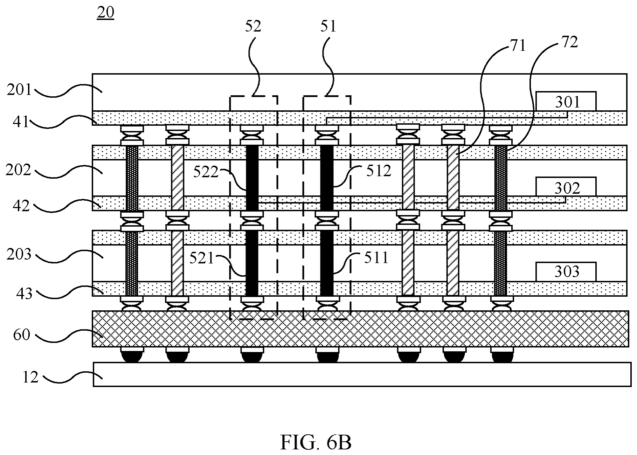

On this basis, as shown in FIG. 6B, the chip stacking structure 20 may further include other TSVs that penetrate through a part of dies, for example, a power supply TSV 71 and a dummy (dummy) TSV 72 that penetrate through the third die 203 and the second die 202. The power supply TSV 71 is configured to electrically connect the die to a power component in the electronic device 01, to supply power to the die.

In addition, in a process of preparing the TSV, preparation precision of the TSV in a middle position is different from that of the TSV in an edge position. Consequently, quality of the TSV in the edge position is affected. Therefore, to reduce a quality difference between a TSV used for signal transmission (for example, the first lower-layer via 511) and a TSV used for power supply connection (for example, the power supply TSV 71) that are distributed in different positions in the chip stacking structure 20, a plurality of dummy TSVs 72 may be disposed at an edge of the TSV, and the dummy TSVs 72 do not need to transmit a signal. A quantity of power supply TSVs 71 and a quantity of dummy TSVs 72 are not limited in this application.

Based on this, still as shown in FIG. 6B, when TSVs that penetrate through the third die 203 and the second die 202 have same distribution positions and same quantities, similarly, active components of the third die 203 and the second die 202 and the TSVs that penetrate through the dies may be prepared in the foregoing homogeneous disposing manner. For example, in a plurality of TSVs that penetrate through the same plurality of chips, pitches (pitch) between two adjacent TSVs may be the same, for example, about 15 µm. Alternatively, the pitches between the two adjacent TSVs may be different. This is not limited in this application.

It can be learned from the foregoing that, the logic die 60 may be electrically connected to the first interface circuit (including the first interface component 301 and at least a part of the first redistribution layer 41) of the first die 201 through the first conductive structure 51. The logic die 60 may be further electrically connected to the second interface circuit (the second interface component 302 and at least a part of the second redistribution layer 42) of the second die 202 through the second conductive structure 52. The following describes, by using an example, a process in which the logic die 60 implements the foregoing connection manner.

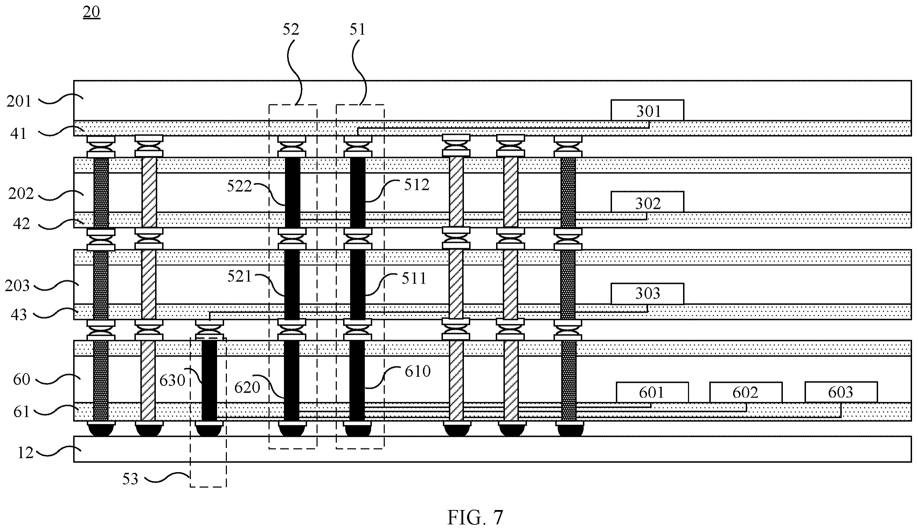

For example, in some embodiments of this application, as shown in FIG. 7, the logic die 60 may include a first logic interface component 601 and a second logic interface component 602. The first logic interface component 601 is electrically connected to the first conductive structure 51, and the second logic interface component 602 is electrically connected to the second conductive structure 52.

Based on this, still as shown in FIG. 7, the chip stacking structure 20 may further include a logic redistribution layer 61 disposed on an active surface A1 of the logic die 60. A manufacturing manner of the logic redistribution layer 61 is the same as the manufacturing method of the foregoing redistribution layer (for example, the first redistribution layer 41). Details are not described herein again. A part of a metal pattern layer at the logic redistribution layer 61 may be electrically connected to the first logic interface component 601 to form a first logic interface circuit of the logic die 60. Similarly, a part of the metal pattern layer at the logic redistribution layer 61 may be electrically connected to the second logic interface component 602 to form a second logic interface circuit of the logic die 60.

The first logic interface circuit of the logic die 60 is electrically connected to the first interface circuit of the first die 201 through the first conductive structure 51, and the first logic interface circuit may be further electrically connected to the processing chip, for example, the CPU. The first logic interface circuit is configured to perform data conversion on a signal from the processing chip, for example, convert serial data into parallel data, and then send the parallel data to the first interface circuit of the first die 201 through the first conductive structure 51. Alternatively, the first logic interface circuit is configured to convert parallel data from the first interface circuit of the first die 201 into serial data, and then send the serial data to the processing chip.

Similarly, the second logic interface circuit of the logic die 60 may be electrically connected to the second interface circuit of the second die 202 through the second conductive structure 52, and the second logic interface circuit may be further electrically connected to the processing chip. A function of the second logic interface circuit is the same as that of the first logic interface circuit, and details are not described herein again.

In this case, to electrically connect the first logic interface component 601 to the first interface circuit of the first die 201, as shown in FIG. 7, in addition to the first lower-layer via 511 and the first middle-layer via 512, the first conductive structure 51 includes a first logic via 610 that penetrates through the logic die 60. The first logic via 610 may further penetrate through the logic redistribution layer 61 and a redistribution layer located on a passive surface of the logic die 60. In addition, one end (for example, an upper end) of the first logic via 610 is electrically connected to the lower end of the first lower-layer via 511, and the other end (for example, a lower end) of the first logic via 610 may be electrically connected to the first logic interface component 601 through the logic redistribution layer 61.

It can be learned from the foregoing that, in one aspect, the upper end of the first logic via 610 is electrically connected to the lower end of the first lower-layer via 511, the first lower-layer via 511 penetrates through the third die 203, and the upper end of the first lower-layer via 511 is electrically connected to the lower end of the first middle-layer via 512. The upper end of the first middle-layer via 512 is electrically connected to the first interface circuit (including the first interface component 301 and at least a part of the first redistribution layer 41) of the first die 201.

In another aspect, the first logic interface component 601 and a part of the metal pattern layer at the logic redistribution layer 61 form the first logic interface circuit of the logic die 60. The lower end of the first logic via 610 is electrically connected to the first logic interface component 601 through the logic redistribution layer 61, that is, the lower end of the first logic via 610 is electrically connected to the first logic interface circuit of the logic die 60. In this way, the first logic interface circuit of the logic die 60 may be electrically connected to the first interface circuit of the first die 201 through the first conductive structure 51.

On this basis, as shown in FIG. 7, a vertical projection of the first lower-layer via 511 on the logic die 60 overlaps a position of the first logic via 610. Similarly, when both the first lower-layer via 511 and the first logic via 610 are TSVs, the first lower-layer via 511 and the first logic via 610 may be coaxially disposed, and diameters of the first lower-layer via 511 and the first logic via 610 are the same or approximately the same. In this way, a pattern difference between the mask for preparing the first lower-layer via 511 and a mask for preparing the first logic via 610 can be reduced, and difficulty in preparing the masks can be reduced.

In addition, to electrically connect the first logic interface component 601 of the logic die 60 to the second interface circuit of the second die 202, still as shown in FIG. 7, when the second conductive structure 52 includes the second lower-layer via 521 that penetrates through the third die 203, the second conductive structure 52 may further include a second logic via 620 that penetrates through the logic die 60. The second logic via 620 may further penetrate through the logic redistribution layer 61 and the redistribution layer located on the passive surface of the logic die 60. In addition, one end (for example, an upper end) of the second logic via 620 is electrically connected to the lower end of the second lower-layer via 521, and the other end (for example, a lower end) of the second logic via 620 may be electrically connected to the second logic interface component 602 through the logic redistribution layer 61.

It can be learned from the foregoing that, in one aspect, the upper end of the second logic via 620 is electrically connected to the lower end of the second lower-layer via 521, the second lower-layer via 521 penetrates through the third die 203, and the upper end of the second lower-layer via 521 is electrically connected to the second interface circuit (including the second interface component 302 and at least a part of the second redistribution layer 42) of the second die 202.

In another aspect, the second logic interface component 602 and a part of the metal pattern layer at the logic redistribution layer 61 form the second logic interface circuit of the logic die 60. The lower end of the second logic via 620 is electrically connected to the second logic interface component 602 through the logic redistribution layer 61, that is, the lower end of the second logic via 620 is electrically connected to the second logic interface circuit of the logic die 60. In this way, the second logic interface circuit of the logic die 60 may be electrically connected to the first interface circuit of the second die 202 through the second conductive structure 52.

On this basis, a vertical projection of the second lower-layer via 521 on the logic die 60 overlaps a position of the second logic via 620. Similarly, when both the second lower-layer via 521 and the second logic via 620 are TSVs, the second lower-layer via 521 and the second logic via 620 may be coaxially disposed, and diameters of the second lower-layer via 521 and the second logic via 620 are the same or approximately the same. In this way, a pattern difference between the mask for preparing the second lower-layer via 521 and a mask for preparing the second logic via 620 can be reduced, and difficulty in preparing the masks can be reduced.

In addition, it can be learned from the foregoing that, still as shown in FIG. 7, the third interface component 303 of the third die 203 and a part of the third redistribution layer 43 located on the active surface of the third die 203 may form the third interface circuit of the third die 203. In addition, the logic die 60 may include a third logic interface component 603. The third logic interface component 603 and at least a part of the logic redistribution layer 61 that is located on an active surface of the logic die 60 may form a third logic interface circuit of the logic die 60. A function of the third logic interface circuit is the same as functions of the first logic interface circuit and the second logic interface circuit, and details are not described herein again.

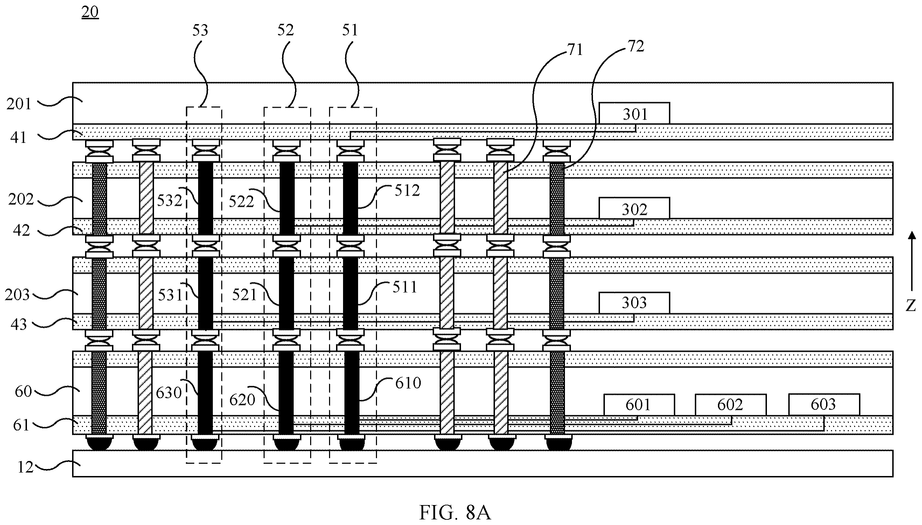

Based on this, to electrically connect the third interface circuit of the third die 203 to the third logic interface circuit of the logic die 60, in some embodiments of this application, as shown in FIG. 7 or FIG. 8A, the chip stacking structure 20 may further include a third conductive structure 53, the third conductive structure 53 may penetrate through at least the logic die 60, and the third conductive structure 53 may be electrically connected to the third logic interface component 603 through the logic redistribution layer 61. The third conductive structure 53 is insulated from the first redistribution layer 41 and the second redistribution layer 42, so that the third conductive structure 53 is insulated from the first conductive structure 51 and the second conductive structure 52.

For example, the third conductive structure 53 may include a third logic via 630, and the third logic via 630 penetrates through the logic die 60. The third logic via 630 may further penetrate through the logic redistribution layer 61 and the redistribution layer located on the passive surface of the logic die 60. In this case, one end (for example, an upper end) of the third logic via 630 may be electrically connected to the third interface component 303 of the third die 203 through the third redistribution layer 43, so that the upper end of the third logic via 630 is electrically connected to the third interface circuit of the third die 203.

In addition, the other end (for example, a lower end) of the third logic via 630 may be electrically connected to the third logic interface component 603 through the logic redistribution layer 61, so that the lower end of the third logic via 630 is electrically connected to the third logic interface circuit of the logic die 60. In this way, the third interface circuit of the third die 203 may be electrically connected to the third logic interface circuit of the logic die 60 through the third conductive structure 53.

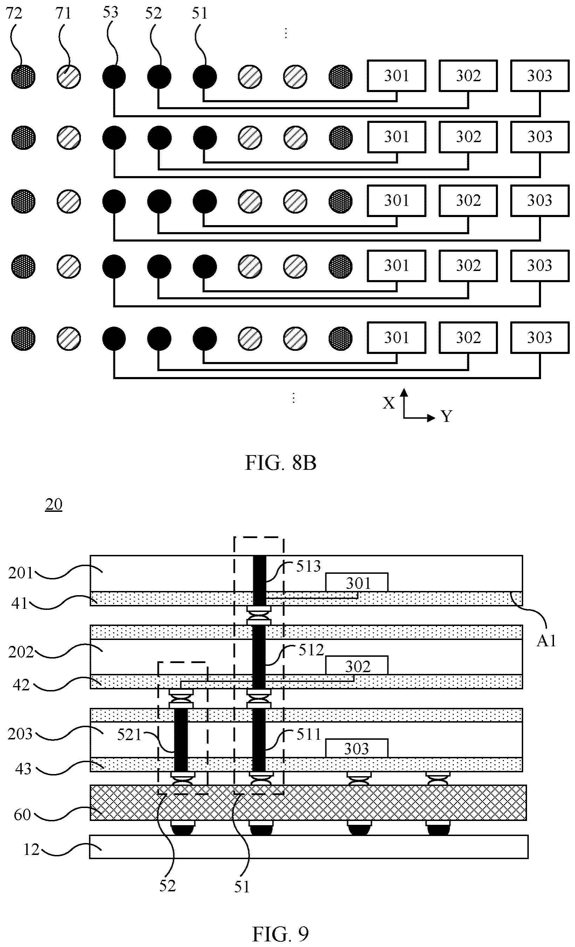

It can be learned from the foregoing that, the third conductive structure 53 is insulated from the first conductive structure 51 and the second conductive structure 52, and the third redistribution layer 43 is insulated from the first conductive structure 51 and the second conductive structure 52. Therefore, the first interface component 301 of the first die 201 is shown in FIG. 8B (a bottom view obtained in a direction Z in FIG. 8A, where a part of a blocking structure is removed from the bottom view), and is electrically connected only to the first conductive structure 51. The second interface component 302 of the second die 202 in FIG. 8A is electrically connected only to the second conductive structure 52 in FIG. 8B. The third interface component 303 of the third die 203 in FIG. 8A is electrically connected only to the third conductive structure 53 in FIG. 8B.

In this way, when the first die 201, the second die 202, and the third die 203 are simultaneously in the operating state, the first interface circuit (including the first interface component 301) of the first die 201, the second interface circuit (including the second interface component 302) of the second die 202, and the third interface circuit (including the third interface component 303) of the third die 203 can transmit a signal to the logic die 60 respectively through the first conductive structure 51, the second conductive structure 52, and the third conductive structure 53 that are insulated from each other.

For example, the chip stacking structure 20 may have eight channels, and each channel has a 128-bit width (that is, has 128 1-bit I/O ports), and has a total of 1024-bit width. Based on this, for example, as shown in FIG. 8B, in a direction X, each die may include 1024 interface circuits, and each interface circuit corresponds to a group of interface components (for example, the first interface component 301). FIG. 8B is described by using an example in which the first conductive structure 51, the second conductive structure 52, and the third conductive structure 53 in each row are arranged in a same sequence in a direction Y. In some other embodiments of this application, the first conductive structure 51, the second conductive structure 52, and the third conductive structure 53 in different rows may be arranged in different sequences. In addition, for ease of description, in FIG. 8B, positions of the first interface component 301, the second interface component 302, and the third interface component 303 are staggered.

On this basis, still as shown in FIG. 8A, the third conductive structure 53 may further include a third lower-layer via 531 and a third middle-layer via 532. The third lower-layer via 531 may penetrate through the third die 203, the third redistribution layer 43, and the redistribution layer located on the passive surface of the third die 203. A vertical projection of the third lower-layer via 531 on the logic die 60 overlaps a position of the third logic via 630. The third middle-layer via 532 penetrates through the second die 202, the second redistribution layer 42, and the redistribution layer located on the passive surface of the second die 202. A vertical projection of the third middle-layer via 532 on the third die 203 overlaps a position of the third lower-layer via 531.

Similarly, when the third lower-layer via 531, the third middle-layer via 532, and the third logic via 630 are all TSVs, the third lower-layer via 531, the third middle-layer via 532, and the third logic via 630 may be coaxially disposed, and diameters of the third lower-layer via 531, the third middle-layer via 532, and the third logic via 630 are the same or approximately the same. In this way, a pattern difference between a mask for preparing the third lower-layer via 531, a mask for preparing the third middle-layer via 532, and a mask for preparing the third logic via 630 can be reduced, and difficulty in preparing the masks can be reduced.

Based on this, as shown in FIG. 8A, when the first conductive structure 51 includes the first logic via 610, the first lower-layer via 511, and the first middle-layer via 512 that are coaxially disposed and have a same diameter or an approximately same diameter, the second conductive structure 52 includes the second logic via 620, the second lower-layer via 521, and the second middle-layer via 522 that are coaxially disposed and have a same diameter or an approximately same diameter, and the third conductive structure 53 includes the third logic via 630, the third lower-layer via 531, and the third middle-layer via 532 that are coaxially disposed and have a same diameter or an approximately same diameter, structures of the logic die 60, the third die 203, and the second die 202 are the same. Therefore, the TSVs may be prepared on different dies in a homogeneous disposing manner, for example, by using a same mask.

It can be learned from the foregoing embodiments that, in the chip stacking structure 20, the first conductive structure 51 may include the first lower-layer via 511 that penetrates through the third die 203 and the first middle-layer via 513 that penetrates through the second die 202. In some other embodiments of this application, as shown in FIG. 9, the first conductive structure 51 may further include a first upper-layer via 513. The first upper-layer via 513 may penetrate through the first die 201, the first redistribution layer 41, and a redistribution layer located on a passive surface of the first die 201. Similarly, the first upper-layer via 513 may be a TSV, and a manufacturing method of the first upper-layer via 513 is similar to the manufacturing methods of the first lower-layer via 511 and the first middle-layer via 512. Details are not described herein again.

For example, a lower end of the first upper-layer via 513 may be electrically connected to the upper end of the first middle-layer via 512. Alternatively, for another example, a lower end of the first upper-layer via 513 may be insulated from the upper end of the first middle-layer via 512.

On this basis, a vertical projection of the first upper-layer via 513 on the third die 203 may overlap the position of the first lower-layer via 511. Similarly, when the first upper-layer via 513, the first middle-layer via 512, and the first lower-layer via 511 are all TSVs, the first upper-layer via 513 may be coaxially disposed with the first middle-layer via 512 and the first lower-layer via 511, and diameters of the first upper-layer via 513, the first middle-layer via 512, and the first lower-layer via 511 are the same or approximately the same. In this way, a pattern difference between a mask for preparing the first upper-layer via 513 and the mask for preparing the first middle-layer via 512 can be reduced, and difficulty in preparing the masks can be reduced.

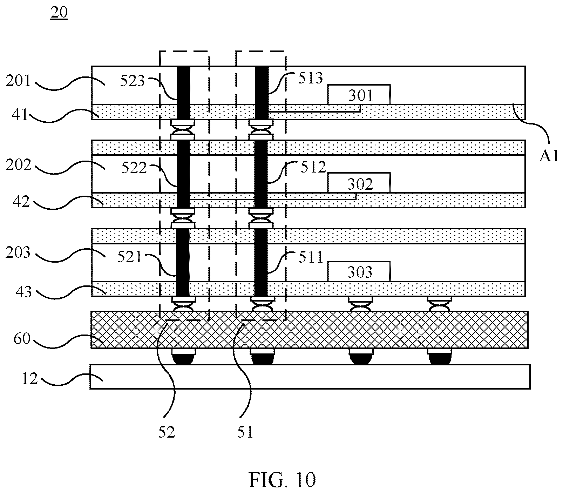

Similarly, as shown in FIG. 10, when the second conductive structure 52 includes the second lower-layer via 521 and the second middle-layer via 522, the second conductive structure 52 may further include a second upper-layer via 523. The second upper-layer via 523 penetrates through the first die 201, the first redistribution layer 41, and the redistribution layer located on the passive surface of the first die 201. Similarly, the second upper-layer via 523 may be a TSV, and a manufacturing method of the second upper-layer via 523 is similar to the manufacturing methods of the first lower-layer via 511 and the first middle-layer via 512. Details are not described herein again.

For example, a lower end of the second upper-layer via 523 may be electrically connected to an upper end of the second middle-layer via 522. Alternatively, for another example, a lower end of the second upper-layer via 523 may be insulated from an upper end of the second middle-layer via 522.

On this basis, a vertical projection of the second upper-layer via 523 on the third die 203 may overlap the position of the second lower-layer via 521. Similarly, when the second upper-layer via 523, the second middle-layer via 522, and the second lower-layer via 521 are all TSVs, the second upper-layer via 523 may be coaxially disposed with the second middle-layer via 522 and the second lower-layer via 521, and diameters of the second upper-layer via 523, the second middle-layer via 522, and the second lower-layer via 521 are the same or approximately the same. In this way, a pattern difference between a mask for preparing the second upper-layer via 523, a mask for preparing the second middle-layer via 522, and a mask for preparing the second lower-layer via 521 can be reduced, and difficulty in preparing the masks can be reduced.

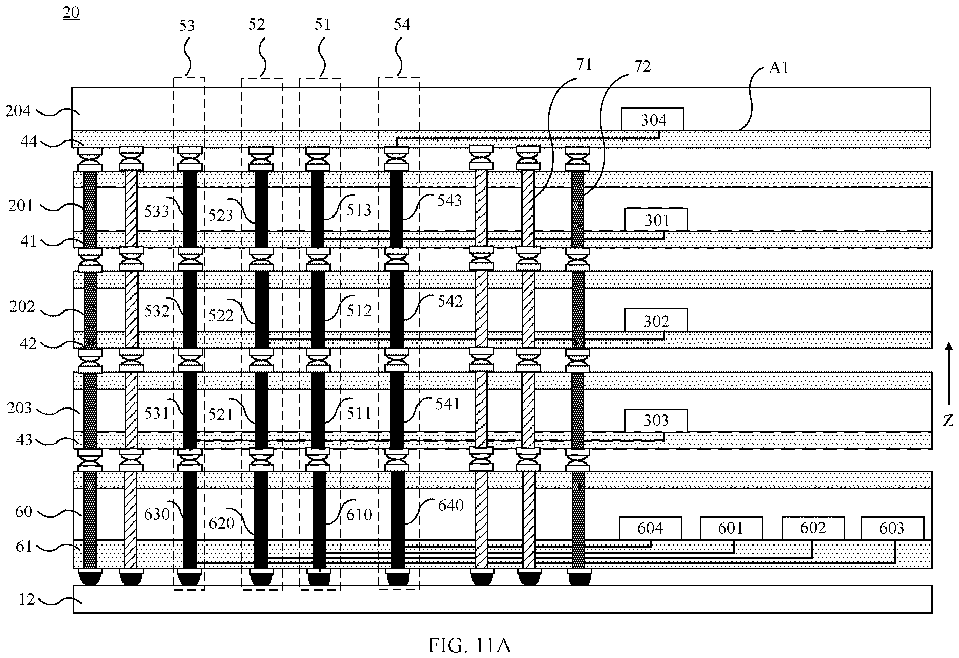

Similarly, as shown in FIG. 11A, when the third conductive structure 53 includes the third lower-layer via 531 and the third middle-layer via 532, the third conductive structure 53 may further include a third upper-layer via 533. The third upper-layer via 533 penetrates through the first die 201, the first redistribution layer 41, and the redistribution layer located on the passive surface of the first die 201. Similarly, the third upper-layer via 533 may be a TSV, and a manufacturing method of the third upper-layer via 533 is similar to the manufacturing methods of the first lower-layer via 511 and the first middle-layer via 512. Details are not described herein again.

For example, a lower end of the third upper-layer via 533 may be electrically connected to an upper end of the third middle-layer via 532. Alternatively, for another example, a lower end of the third upper-layer via 533 may be insulated from an upper end of the third middle-layer via 532.

On this basis, a vertical projection of the third upper-layer via 533 on the third die 203 may overlap the position of the third lower-layer via 531. Similarly, when the third upper-layer via 533, the third middle-layer via 532, and the third lower-layer via 531 are all TSVs, the third upper-layer via 533 may be coaxially disposed with the third middle-layer via 532 and the third lower-layer via 531, and diameters of the third upper-layer via 533, the third middle-layer via 532, and the third lower-layer via 531 are the same or approximately the same. In this way, a pattern difference between a mask for preparing the third upper-layer via 533, a mask for preparing the third middle-layer via 532, and a mask for preparing the third lower-layer via 531 can be reduced, and difficulty in preparing the masks can be reduced.

In some other embodiments of this application, as shown in FIG. 11A, when the chip stacking structure 20 includes the first upper-layer via 513, the second upper-layer via 523, and the third upper-layer via 533 that penetrate through the first die 201, the chip stacking structure 20 may further include a fourth die 204 located on a side above the first die 201 (away from the carrier board 12). In addition, the chip stacking structure 20 further includes a fourth conductive structure 54 and a fourth redistribution layer 44. The fourth die 204 may be a storage die.

Still as shown in FIG. 11A, the fourth redistribution layer 44 is disposed on an active surface A1 of the fourth die 204. The fourth die 204 may include a fourth interface component 304. The fourth interface component 304 is electrically connected to the fourth redistribution layer 44. The fourth interface component 304 and at least a part of a metal line structure at the fourth redistribution layer 44 may form a fourth interface circuit of the fourth die 204. A function of the fourth interface circuit is the same as that of the first interface circuit, and details are not described herein again.

In addition, the logic die 60 further includes a fourth logic interface component 604. The fourth logic interface component 604 and a part of the logic redistribution layer 61 may form a fourth logic interface circuit of the logic die 60. The fourth conductive structure 54 penetrates through at least the first die 201, the second die 202, and the third die 203. The fourth conductive structure 54 is electrically connected to the fourth redistribution layer 44 and the fourth logic interface component 604. In this way, the fourth interface circuit that is of the fourth die 204 and that includes the fourth redistribution layer 44 and the fourth interface component 304 may be electrically connected to the fourth logic interface circuit of the logic die 60 through the fourth conductive structure 54, to implement signal interworking between the fourth die 204 and the logic die 60.

In addition, the fourth conductive structure 54 is insulated from the first redistribution layer 41, the second redistribution layer 42, and the third redistribution layer 43, and the fourth redistribution layer 44 is insulated from the first conductive structure 51, the second conductive structure 52, and the third conductive structure 53. Similarly, the fourth redistribution layer 44, the first redistribution layer 41, the second redistribution layer 42, and the third redistribution layer 43 may be disposed in a heterogeneous manner. To be specific, the first redistribution layer 41, the second redistribution layer 42, the third redistribution layer 43, and the fourth redistribution layer 44 may be manufactured by using different masks, so that patterns of the first redistribution layer 41, the second redistribution layer 42, the third redistribution layer 43, and the fourth redistribution layer 44 are different.

In this way, a metal pattern at the fourth redistribution layer 44 only needs to be electrically connected to the fourth interface component 304 and the fourth conductive structure 54, so that the fourth interface circuit that is of the fourth die 204 and that includes the fourth redistribution layer 44 and the fourth interface component 304 is electrically connected to the fourth conductive structure 54. The fourth conductive structure 54 does not need to be electrically connected to the first interface circuit of the first die 201, the second interface circuit of the second die 202, and the third interface circuit of the third die 203.

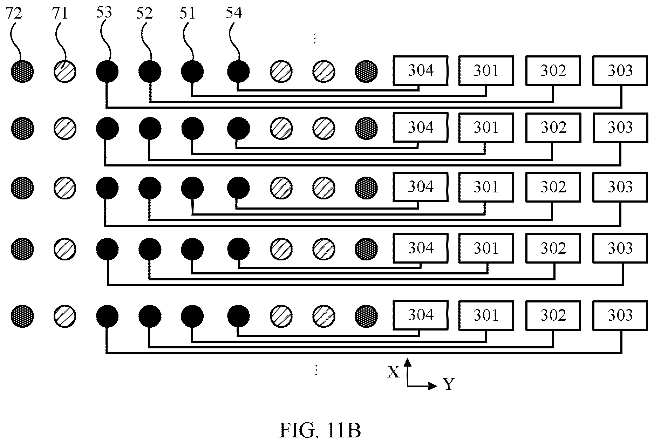

In this case, the fourth interface component 304 of the fourth die 204 is shown in FIG. 11B (a bottom view obtained in a direction Z in FIG. 11A, where a part of a blocking structure is removed from the bottom view), and is electrically connected only to the fourth conductive structure 54. The fourth interface component 304 of the fourth die 204 and the fourth conductive structure 54 may form an independent signal path of the fourth die 204, and the signal path is electrically connected to one 1-bit I/O port of the chip stacking structure.

Similarly, FIG. 11B is described by using an example in which the first conductive structure 51, the second conductive structure 52, the third conductive structure 53, and the fourth conductive structure 54 in each row are arranged in a same sequence in a direction Y. In some other embodiments of this application, the first conductive structure 51, the second conductive structure 52, the third conductive structure 53, and the fourth conductive structure 54 in different rows may be arranged in different sequences. In addition, a manner of disposing the power supply TSV 71 and the dummy TSV 72 in FIG. 11B is the same as that described above, and details are not described herein again.

On this basis, still as shown in FIG. 11B, the fourth conductive structure 54 may include a fourth upper-layer via 543, a fourth middle-layer via 542, a fourth lower-layer via 541, and a fourth logic via 640. The fourth upper-layer via 543 penetrates through the first die 201, the first redistribution layer 41, and the redistribution layer located on the passive surface of the first die 201. One end (for example, an upper end) of the fourth upper-layer via 543 is electrically connected to the fourth redistribution layer 44, so that the fourth upper-layer via 543 can be electrically connected to the fourth interface circuit (including the fourth interface component 304 and a part of the fourth redistribution layer 44) of the fourth die 204.

The fourth middle-layer via 542 penetrates through the second die 202, the second redistribution layer 42, and the redistribution layer on the passive surface of the second die 202. One end (for example, an upper end) of the fourth middle-layer via 542 is electrically connected to the other end (for example, a lower end) of the fourth upper-layer via 543. The fourth lower-layer via 541 penetrates through the third die 203, the third redistribution layer 43, and the redistribution layer on the passive surface of the third die 203. One end (for example, an upper end) of the fourth lower-layer via 541 is electrically connected to the other end (for example, a lower end) of the fourth middle-layer via 542. The fourth logic via 640 penetrates through the logic die 60, the logic redistribution layer 61, and the redistribution layer on the passive surface of the logic die 60. Two ends of the fourth logic via 640 are electrically connected to the other end (for example, a lower end) of the fourth lower-layer via 541 and the fourth logic interface component 604 respectively.

In this way, the fourth upper-layer via 543, the fourth middle-layer via 542, the fourth lower-layer via 541, and the fourth logic via 640 are electrically connected in sequence, to form the fourth interface circuit (including the fourth interface component 304 and the part of the fourth redistribution layer 44) of the fourth die 204, and a signal path between the fourth interface circuit and the fourth logic interface circuit (including the fourth logic interface component 604 and a part of the logic redistribution layer 61) of the logic die 60.

A vertical projection of the fourth upper-layer via 543 on the logic die 60, a vertical projection of the fourth middle-layer via 542 on the logic die 60, and a vertical projection of the fourth lower-layer via 541 on the logic die 60 overlap a position of the fourth logic via 640. Similarly, when the fourth upper-layer via 543, the fourth middle-layer via 542, the fourth lower-layer via 541, and the fourth logic via 640 are all TSVs, the fourth upper-layer via 543, the fourth middle-layer via 542, the fourth lower-layer via 541, and the fourth logic via 640 may be coaxially disposed, and diameters of the fourth upper-layer via 543, the fourth middle-layer via 542, the fourth lower-layer via 541, and the fourth logic via 640 are the same or approximately the same. In this way, a pattern difference between a mask for preparing the fourth upper-layer via 543, a mask for preparing the fourth middle-layer via 542, a mask for preparing the fourth lower-layer via 541, and a mask for preparing the fourth logic via 640 can be reduced, and difficulty in preparing the masks can be reduced.

Based on this, as shown in FIG. 11A, when TSVs on any one of the logic die 60, the third die 203, the second die 202, and the first die 201 have same quantities, sizes, and distribution manners, a homogeneous disposing manner may be used, for example, the TSVs are prepared on different dies by using a same mask.

The foregoing uses an example in which the chip stacking structure 20 includes one logic die 60 and three storage dies (for example, the first die 201, the second die 202, and the third die 203 shown in FIG. 8A) or four storage dies (for example, the first die 201, the second die 202, the third die 203, and the fourth die 204 shown in FIG. 8A) for description, and does not constitute a limitation on a quantity of stacked dies in the chip stacking structure 20. For example, when a storage speed and a capacity of the chip stacking structure 20 need to be increased, a quantity of the foregoing storage dies may be increased.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A chip stacking structure, comprising:
a carrier board;
a first die, disposed on the carrier board and comprising a first interface component;
a second die, disposed between the carrier board and the first die, and comprising a second interface component;
a third die, disposed between the carrier board and the second die;
a first conductive structure, penetrating through at least the second die and the third die;
a second conductive structure, penetrating through at least the third die;
a first redistribution layer, disposed on an active surface of the first die, electrically connected to the first interface component and the first conductive structure, and insulated from the second conductive structure; and
a second redistribution layer, disposed on an active surface of the second die, electrically connected to the second interface component and the second conductive structure, and insulated from the first conductive structure.

2. The chip stacking structure according to claim 1, wherein the first conductive structure comprises:
a first middle-layer via, penetrating through the second die, wherein one end of the first middle-layer via is electrically connected to the first redistribution layer; and
a first lower-layer via, penetrating through the third die, wherein one end of the first lower-layer via is electrically connected to the other end of the first middle-layer via.

3. The chip stacking structure according to claim 2, wherein
a vertical projection of the first middle-layer via on the third die overlaps a position of the first lower-layer via.

4. The chip stacking structure according to claim 3, wherein the first conductive structure further comprises:
a first upper-layer via, penetrating through the first die, wherein a vertical projection of the first upper-layer via on the third die overlaps the position of the first lower-layer via.

5. The chip stacking structure according to any one of claims 1 to 4, wherein the second conductive structure comprises:
a second lower-layer via, penetrating through the third die, wherein one end of the second lower-layer via is electrically connected to the second redistribution layer.

6. The chip stacking structure according to claim 5, wherein the second conductive structure further comprises:
a second middle-layer via, penetrating through the second die, wherein a vertical projection of the second middle-layer via on the third die overlaps a position of the second lower-layer via; and
a second upper-layer via, penetrating through the first die, wherein a vertical projection of the second upper-layer via on the third die overlaps the position of the second lower-layer via.

7. The chip stacking structure according to any one of claims 1 to 6, wherein
the first die, the second die, and the third die are storage dies;
the chip stacking structure further comprises a logic die, the logic die is disposed on the carrier board, and the logic die comprises a first logic interface component and a second logic interface component; and
the first logic interface component is electrically connected to the first conductive structure, and the second logic interface component is electrically connected to the second conductive structure.

8. The chip stacking structure according to claim 7, wherein
the logic die is disposed between the third die and the carrier board;
the first conductive structure comprises the first middle-layer via and the first lower-layer via; the first middle-layer via penetrates through the first die, and two ends of the first middle-layer via are electrically connected to the first redistribution layer and the first lower-layer via respectively; and the first lower-layer via penetrates through the third die; and
the first conductive structure further comprises a first logic via that penetrates through the logic die, and two ends of the first logic via are electrically connected to the first lower-layer via and the first logic interface component respectively.

9. The chip stacking structure according to claim 8, wherein
a vertical projection of the first lower-layer via on the logic die overlaps a position of the first logic via.

10. The chip stacking structure according to any one of claims 7 to 9, wherein
the logic die is disposed between the third die and the carrier board;
the second conductive structure comprises the second lower-layer via that penetrates through the third die, and one one end of the second lower-layer via is electrically connected to the second redistribution layer; and
the second conductive structure further comprises a second logic via that penetrates through the logic die, and two ends of the second logic via are electrically connected to the other end of the second lower-layer via and the second logic interface component respectively.

11. The chip stacking structure according to claim 10, wherein
a vertical projection of the second lower-layer via on the logic die overlaps a position of the second logic via.

12. The chip stacking structure according to any one of claims 7 to 11, wherein
the third die comprises a third interface component, the logic die is disposed between the third die and the carrier board, and the logic die further comprises a third logic interface component; and
the chip stacking structure further comprises:
a third conductive structure, penetrating through at least the logic die, wherein the third conductive structure is electrically connected to the third logic interface component, and the third conductive structure is insulated from the first redistribution layer and the second redistribution layer; and
a third redistribution layer, disposed on an active surface of the third die, electrically connected to the third interface component and the third conductive structure, and insulated from the first conductive structure and the second conductive structure.

13. The chip stacking structure according to claim 12, wherein the third conductive structure comprises:
a third logic via, penetrating through the logic die, wherein two ends of the third logic via are electrically connected to the third redistribution layer and the third logic interface component respectively.

14. The chip stacking structure according to claim 13, wherein the third conductive structure further comprises:
a third lower-layer via, penetrating through the third die, wherein a vertical projection of the third lower-layer via on the logic die overlaps a position of the third logic via;
a third middle-layer via, penetrating through the second die, wherein a vertical projection of the third middle-layer via on the third die overlaps a position of the third lower-layer via; and
a third upper-layer via, penetrating through the first die, wherein a vertical projection of the third upper-layer via on the third die overlaps the position of the third lower-layer via.

15. The chip stacking structure according to any one of claims 7 to 14, wherein
the logic die is disposed between the third die and the carrier board, and the logic die further comprises a fourth logic interface component; and
the chip stacking structure further comprises:
a fourth die, disposed on a side that is of the first die and that is away from the second die, and comprising a fourth interface component;
a fourth conductive structure, penetrating through at least the first die, the second die, and the third die, wherein the fourth conductive structure is electrically connected to the fourth logic interface component, and the fourth conductive structure is insulated from the first redistribution layer and the second redistribution layer; and
a fourth redistribution layer, disposed on an active surface of the fourth die, electrically connected to the fourth interface component and the fourth conductive structure, and insulated from the first conductive structure and the second conductive structure.

16. The chip stacking structure according to claim 15, wherein the fourth conductive structure comprises:
a fourth upper-layer via, penetrating through the first die, wherein one end of the fourth upper-layer via is electrically connected to the fourth redistribution layer;
a fourth middle-layer via, penetrating through the second die, wherein one end of the fourth middle-layer via is electrically connected to the other end of the fourth upper-layer via;
a fourth lower-layer via, penetrating through the third die, wherein one end of the fourth lower-layer via is electrically connected to the other end of the fourth middle-layer via; and
a fourth logic via, penetrating through the logic die, wherein two ends of the fourth logic via are electrically connected to the other end of the fourth lower-layer via and the fourth logic interface component respectively, wherein
a vertical projection of the fourth upper-layer via on the logic die, a vertical projection of the fourth middle-layer via on the logic die, and a vertical projection of the fourth lower-layer via on the logic die overlap a position of the fourth logic via.

17. An electronic device, comprising:
a printed circuit board; and
the chip stacking structure according to any one of claims 1 to 16, wherein the chip stacking structure is disposed on the printed circuit board and is electrically connected to the printed circuit board.
